# EUROPEAN PATENT APPLICATION

(11) **EP 4 597 558 A1**
(43) Date of publication of application: **06.08.2025**
(21) Application number: 23871315.0
(22) Date of filing: 13.06.2023
(51) Int. Cl.: H01L 21/683, H05B 3/20

(54) **STAGE**

(30) Priority: 30.09.2022 JP 2022158088
(71) Applicant: NHK Spring Co., Ltd., Yokohama-shi, Kanagawa 236-0004 (JP)
(72) Inventor: FUTAKUCHIYA, Jun, Yokohama-shi, Kanagawa 236-0004 (JP); AIKAWA, Naoya, Yokohama-shi, Kanagawa 236-0004 (JP)
(74) Representative: dompatent von Kreisler Selting Werner - Partnerschaft von Patent- und Rechtsanwälten mbB
(86) International application number: PCT/JP2023/021868
(87) International publication number: WO 2024/070070

(57) **Abstract**

A stage includes a first metal plate, a second metal plate below the first metal plate, a heat insulating portion including a first space provided in the first metal plate and a second space provided in the second metal plate, and a circulating flow path and a heater with the insulating portion therebetween. In a cross-sectional view, a width of the heat insulating portion in the first metal plate is different from a width of the heat insulating portion in the second metal plate.

## Description

### TECHNICAL FIELD

An embodiment of the present invention relates to a stage on which a wafer or the like is placed.

### BACKGROUND ART

A semiconductor apparatus for manufacturing a semiconductor element is provided with a stage on which a wafer is placed. Ceramics are generally used for the stage from the viewpoints of the degree of freedom in heater arrangement, contamination, heat resistance, and the like. For example, for a stage using ceramics, Patent Literature 1 discloses a ceramic plate having a temperature gradient profile in which the temperature of the inner peripheral region and the temperature of the outer peripheral region are different by controlling a heater element in the inner peripheral region and a heater element in the outer peripheral region, respectively. In the ceramic plate disclosed in the Patent Literature 1, the temperature increases from the inner peripheral region toward the outer peripheral region, and it is possible to achieve a temperature gradient profile in which the temperature difference between the inner peripheral region and the outer peripheral region is about 10°C.

### CITATION LIST

### PATENT LITERATURE

Patent Literature 1: International patent publication No. WO2018/030433

### SUMMARY OF INVENTION

### TECHNICAL PROBLEM

In recent years, there has been demand for a larger temperature difference between the inner and outer regions of a stage. However, when the temperature difference between the inner region and the outer region exceeds 10°C in a stage using ceramics, the stage may be damaged.

In view of the above problem, one object of an embodiment of the present invention is to provide a stage capable of achieving a temperature gradient profile with a large temperature difference between an inner region and an outer region.

### SOLUTION TO PROBLEM

A stage according to an embodiment of the present invention includes a first metal plate, a second metal plate below the first metal plate, a heat insulating portion including a first space provided in the first metal plate and a second space provided in the second metal plate, and a circulating flow path and a heater with the insulating portion therebetween. In a cross-sectional view, a width of the heat insulating portion in the first metal plate is different from a width of the heat insulating portion in the second metal plate.

A stage according to an embodiment of the present invention includes a first metal plate including a first groove, a second metal plate including a through hole below the first metal plate, a third metal plate including a second groove below the second metal plate, and a circulating flow path and a heater with the first groove interposed therebetween. The first groove, the through hole, and the second groove are connected to one another.

In a cross-sectional view, a width of the first groove is different from a width of at least one of the through hole and the second groove.

Further, a stage according to an embodiment of the present invention includes a first metal plate including a first through hole, a second metal plate including a second through hole below the first metal plate, a third metal plate including a groove, below the second metal plate, and a circulating flow path and a heater with the first through hole interposed therebetween. The first through hole, the second through hole, and the groove are connected to one another.

In a cross-sectional view, a width of the first through hole is different from a width of at least one of the second through hole and the groove.

In a cross-sectional view, at least one of the first through hole, the second through hole, and the groove have a tapered shape. The tapered shape may increase in width toward a surface of the first metal plate. The tapered shape may decrease in width toward a surface of the first metal plate.

Furthermore, a stage according to an embodiment of the present invention includes a first metal plate including a first groove, and a circulating flow path and a heater with the first groove therebetween, a second metal plate including a through hole below the first metal plate, and a third metal plate including a second groove below the second metal plate. The through hole and the second groove are connected to each other. The first groove overlaps the through hole. One end of the through hole is closed by the first plate.

In a cross-sectional view, a width of the first groove is different from a width of at least one of the through hole and the second groove.

A temperature difference between a minimum surface temperature and a maximum surface temperature of the first metal plate may be higher than or equal to 20°C.

### ADVANTAGEOUS EFFECTS OF INVENTION

A stage according to an embodiment of the present invention can achieve a temperature gradient profile with a large temperature difference between an inner region and an outer region. Therefore, even when a temperature drop in the outer region of a wafer placed on the stage is significant, the temperature of the outer region of the wafer can be corrected to uniformize the temperature distribution in the wafer.

### BRIEF DESCRIPTION OF DRAWINGS

FIG. 1 is a schematic perspective view showing a configuration of a stage according to an embodiment of the present invention.
FIG. 2 is a schematic top view showing a configuration of a stage according to an embodiment of the present invention.
FIG. 3 is a schematic cross-sectional view showing a configuration of a stage according to an embodiment of the present invention.
FIG. 4A is a schematic plan view showing a configuration of a circulating flow path of a stage according to an embodiment of the present invention .
FIG. 4B is a schematic plan view showing a configuration of a circulating flow path of a stage according to an embodiment of the present invention.
FIG. 5 is a schematic cross-sectional view showing a configuration of a heat insulating portion of a stage according to an embodiment of the present invention.
FIG. 6 is a schematic plan view showing a configuration of a second metal plate of a stage according to an embodiment of the present invention.
FIG. 7 is a schematic plan view showing a configuration of a second metal plate of a stage according to an embodiment of the present invention.
FIG. 8 is a graph illustrating a temperature gradient profile of a stage according to an embodiment of the present invention.
FIG. 9 is a schematic cross-sectional view showing a configuration of a heat insulating portion of a stage according to an embodiment of the present invention.
FIG. 10 is a schematic cross-sectional view showing a configuration of a heat insulating portion of a stage according to an embodiment of the present invention.
FIG. 11 is a schematic cross-sectional view showing a configuration of a heat insulating portion of a stage according to an embodiment of the present invention.
FIG. 12 is a schematic cross-sectional view showing a configuration of a heat insulating portion of a stage according to an embodiment of the present invention.
FIG. 13 is a schematic top view showing a configuration of a stage according to an embodiment of the present invention.
FIG. 14 is a schematic cross-sectional view showing a configuration of a heat insulating portion of a stage according to an embodiment of the present invention.
FIG. 15 is a schematic cross-sectional view showing a configuration of a heat insulating portion of a stage according to an embodiment of the present invention.
FIG. 16 is a schematic cross-sectional view showing a configuration of a heat insulating portion of a stage according to an embodiment of the present invention.
FIG. 17 is a schematic cross-sectional view showing a configuration of a heat insulating portion of a stage according to an embodiment of the present invention .
FIG. 18 is a schematic cross-sectional view showing a configuration of a heat insulating portion of a stage according to an embodiment of the present invention.
FIG. 19 is a schematic cross-sectional view showing a configuration of a heat insulating portion of a stage according to an embodiment of the present invention.
FIG. 20 is a schematic cross-sectional view showing a configuration of a heat insulating portion of a stage according to an embodiment of the present invention.
FIG. 21 is a schematic cross-sectional view showing a configuration of a heat insulating portion of a stage according to an embodiment of the present invention.
FIG. 22 is a schematic cross-sectional view showing a configuration of a heat insulating portion of a stage according to an embodiment of the present invention.
FIG. 23 is a schematic cross-sectional view showing a configuration of an etching apparatus according to an embodiment of the present invention.
FIG. 24 is a schematic cross-sectional view showing a configuration of a CVD apparatus according to an embodiment of the present invention.
FIG. 25 is a schematic cross-sectional view showing a configuration of a sputtering apparatus according to an embodiment of the present invention.
FIG. 26 is a schematic cross-sectional view showing a configuration of an evaporation apparatus according to an embodiment of the present invention.

### DESCRIPTION OF EMBODIMENTS

Hereinafter, embodiments of the invention disclosed in the present application are described with reference to the drawings. However, the present invention can be implemented in various forms without departing from the gist thereof and should not be construed as being limited to the description of the following exemplary embodiments.

For the sake of clarity of description, the drawings may be schematically represented with respect to widths, thicknesses, shapes, and the like of the respective portions compared with actual embodiments. However, the drawings are merely an example and do not limit the interpretation of the present invention. In the present specification and the respective drawings, components having the same functions as those described with reference to the preceding drawings are denoted by the same reference numerals, and a duplicate description thereof may be omitted. Further, although the terms "upper" and "lower" are used in the explanation, the terms "upper" and "lower" respectively indicate the direction when the stage is in use (when a wafer is placed on the stage).

In the specification and the drawings, the same reference numerals are used when multiple components are identical or similar in general, and reference numerals with a lower or upper case letter of the alphabet are used when the multiple components are distinguished. Further, reference numerals with a hyphen and a natural number are used when multiple portions of one component are distinguished.

In the present specification, an "inner region" of a stage refers to a region inside and surrounded by a heat insulating portion and a region overlapping the region. Further, in the present specification, an "outer region" of the stage refers to a region outside the inner region. In other words, the "outer region" is a region on an outer periphery of the stage. In addition, although in the present specification, the terms "inner region" and "outer region" are used not only for the stage but also for the wafer, the "inner region" and the "outer region" of the wafer refer to regions that overlap with the "inner region" and the "outer region" of the stage, respectively when the wafer is placed on the stage.

### <First Embodiment>

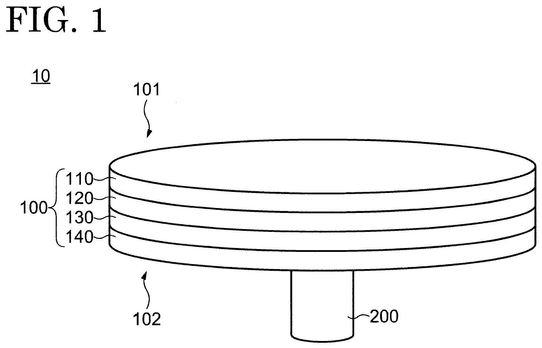

A stage 10 according to an embodiment of the present invention is described with reference to FIGS. 1 to 8.

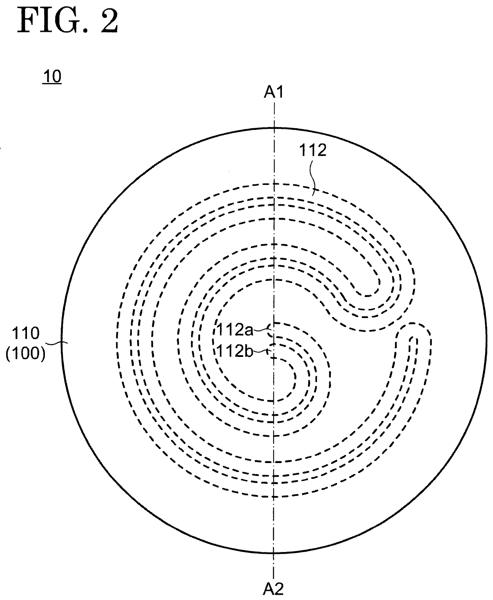

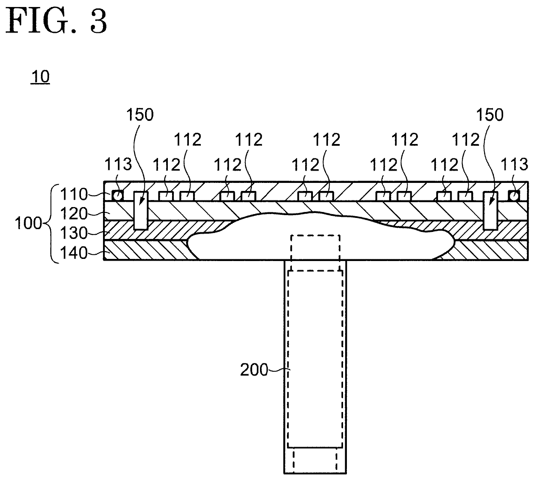

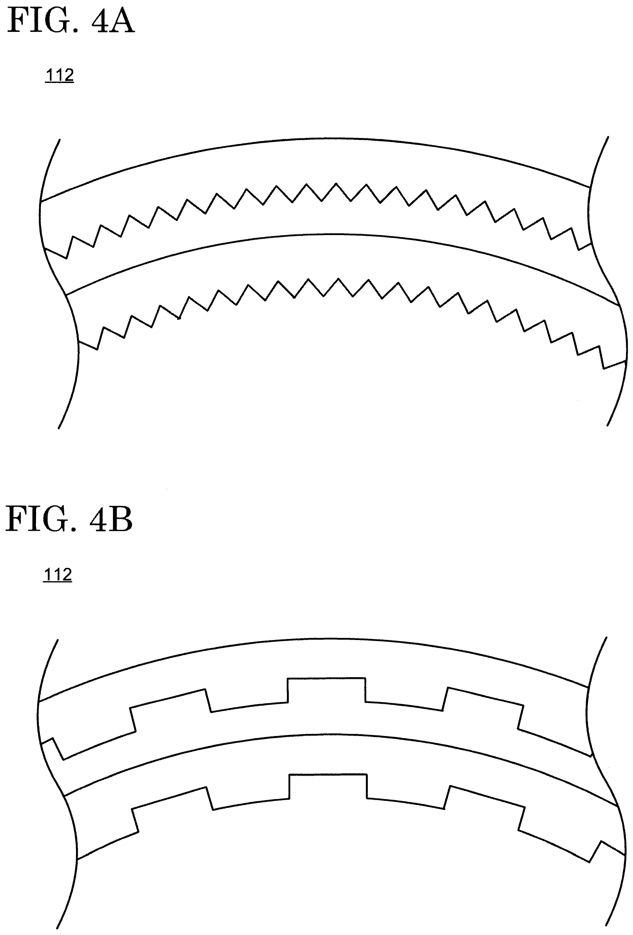

FIG. 1 is a schematic perspective view showing a configuration of the stage 10 according to an embodiment of the present invention. FIG. 2 is a schematic top view showing the configuration of the stage 10 according to an embodiment of the present invention. In FIG. 2, a circulating flow path 112, which is described later, is indicated by a dotted line. FIG. 3 is a cross-sectional view showing the configuration of the stage 10 according to an embodiment of the present invention. Specifically, FIG. 3 is a cross-sectional view showing a cross section of a portion of the stage 10 taken along the line A1-A2 shown in FIG. 2. Each of FIGS. 4A and 4B is a schematic cross-sectional view showing a configuration of the circulating flow path 112 of the stage 10 according to an embodiment of the present invention.

As shown in FIG. 1, the stage 10 includes a plate portion 100 and a shaft portion 200. In the stage 10, a wafer is placed on a first surface 101 of the plate portion 100. The shaft portion 200 is connected to a second surface 102 of the plate portion 100 opposite to the first surface 101.

For example, although silicon (Si), silicon carbide (SiC), sapphire, quartz, glass, gallium phosphide (GaP), gallium arsenide (GaAs), indium phosphide (InP), or gallium nitride (GaN) is used for the wafer placed on the stager 10, a material of the wafer is not limited thereto. As described above, since the wafer is placed on the first surface 101 of the plate portion 100, the first surface 101 may be provided with a step for guiding the wafer to be placed.

The plate portion 100 includes a first metal plate 110, a second metal plate 120, a third metal plate 130, and a fourth metal plate 140. The first metal plate 110 to the fourth metal plate 140 are stacked in this order. That is, the second metal plate 120 is located below the first metal plate 110, the third metal plate 130 is located below the second metal plate 120, and the fourth metal plate 140 is located below the third metal plate 130.

The first metal plate 110 and the second metal plate 120, the second metal plate 120 and the third metal plate 130, and the third metal plate 130 and the fourth metal plate 140 are bonded to each other by welding, screwing, solid-state diffusion bonding, or brazing, etc. For example, an alloy containing silver, copper, and zinc, an alloy containing copper and zinc, copper containing a trace amount of phosphorus, an alloy containing aluminum, an alloy containing titanium, copper, and nickel, an alloy containing titanium, zirconium, and copper, or an alloy containing titanium, zirconium, copper, and nickel can be used as the brazing material.

As shown in FIG. 2, the first metal plate 110 has a circular shape when viewed from above. The second metal plate 120 to the fourth metal plate 140 overlapping the first metal plate 110 also have a circular shape. However, the shapes of the first metal plate 110 to the fourth metal plate 140 are not limited to a circular shape. The shapes of the first metal plate 110 to the fourth metal plate 140 may be appropriately determined according to the shape of the wafer, and the first metal plate 110 to the fourth metal plate 140 may have an elliptical shape or a polygonal shape.

Further, the thicknesses of the first metal plate 110 to the fourth metal plate 140 may be the same or different.

For example, a metal such as aluminum, titanium, iron, copper, nickel, molybdenum, tungsten, or gold, or an alloy containing these metals is used as a material of the first metal plate 110 to the fourth metal plate 140. The alloy containing iron is, for example, stainless steel, Kovar, or 42 alloy. The alloy containing nickel is, for example, Inconel or Hastelloy. As described later, the first metal plate 110 is provided with a circulating flow path 112 through which a cooling medium flows, and a heater 113. The surface of the first metal plate 110 corresponds to the first surface 101 of the plate portion 100, and the wafer is placed on the surface of the first metal plate 110. Therefore, it is preferable to use a material with high thermal conductivity for the first metal plate 110 in order to efficiently conduct the heat generated by the heater 113 to the wafer and efficiently absorb the heat by the cooling medium flowing through the circulation flow path 112. For example, a metal or alloy having a thermal conductivity greater than or equal to 200 W/mK and less than or equal to 430 W/mK can be used as the material of the first metal plate 110. The first metal plate 110 to the fourth metal plate 140 may be made of the same material or different materials. When the first metal plate 110 to the fourth metal plate 140 are different, it is preferable that the metal or alloy contained in the first metal plate 110 to the fourth metal plate 140 has a thermal expansion coefficient greater than or equal to 5×10⁻⁶ /K and less than or equal to 25×10⁻⁶ /K. Further, it is preferable that the materials of the two adjacent metal plates are selected so that the difference in the thermal expansion coefficient is less than or equal to 10×10⁻⁶ /K. Thus, since a deformation of the stage 10 due to differences in thermal expansion is suppressed, the reliability of the stage 10 can be improved.

As shown in FIG. 3, the first metal plate 110 includes the circulating flow path 112 and the heater 113. The circulating flow path 112 and the heater 113 of the first metal plate 110 are provided on the side of the second metal plate 120, and are closed by the second metal plate 120. Further, the circulating flow path 112 is provided in an inner region of the plate portion 100, and the heater 113 is provided in an outer region of the plate portion 100.

A cooling medium including a liquid such as water or a gas, is introduced into the circulating flow path 112 from an inlet 112a, and after circulating widely through the first metal plate 110 along the circulating flow path 112, the cooling medium is discharged from an outlet 112b to the outside of the first metal plate 110 (see FIG. 2). The circulation of the cooling medium causes heat exchange between the cooling medium and the plate portion 100 or the wafer, and the inner region of the wafer is cooled. The circulating flow path 112 may be a structure formed directly in the first metal plate 110, or may be a structure in which a tubular member is disposed in a groove provided in the first metal plate 110.

In a plan view, although the circulating flow path 112 shown in FIG. 2 has a smoothly curved shape (i.e., the side surface of the circulating flow path 112 has a smoothly curved surface), the configuration of the circulating flow path 112 is not limited thereto. For example, as shown in FIG. 4A, the circulating flow path 112 may have a zigzag shape in a plan view. Further, as shown in FIG. 4B, the circulating flow path 112 may have an uneven shape in a plan view. In other words, the width of the circulating flow path 112 may not be constant in the circumferential direction, and may vary.

The heater 113 is driven under the control of a control device (not shown in the figures). For example, the heater 113 is configured using an electric heating wire and is arranged along the outer periphery of the first metal plate 110. The heater 113 may be embedded in the first metal plate 110, or may be arranged in a groove provided in the first metal plate 110. For example, the heater 113 can be located on the first metal plate 110 by covering the heater 113 with a sprayed firm or the like after arranging the heater 113 in the groove of the first metal plate 110. The heater 113 heats the outer region of the wafer through the first metal plate 110.

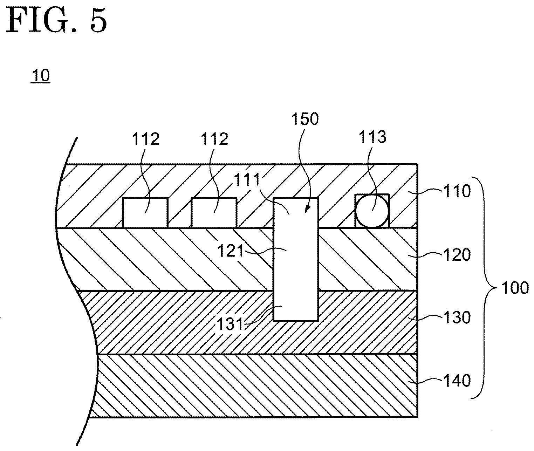

In the plate portion 100, a heat insulating portion 150 is provided between the circulating flow path 112 arranged in the inner region of the first metal plate 110 and the heater 113 arranged in the outer region of the first metal plate 110. Here, a configuration of the heat insulating portion 150 is described with reference to FIGS. 5 to 7.

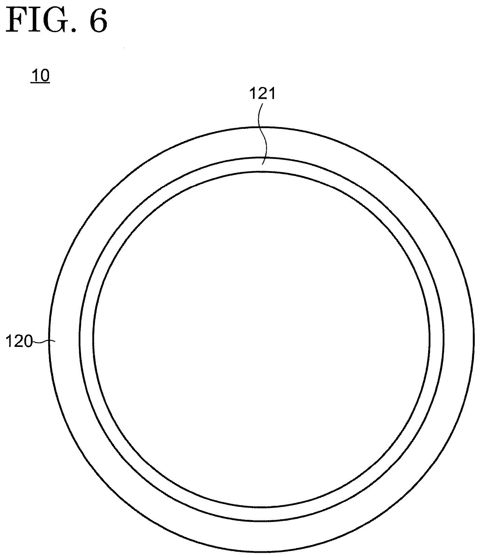

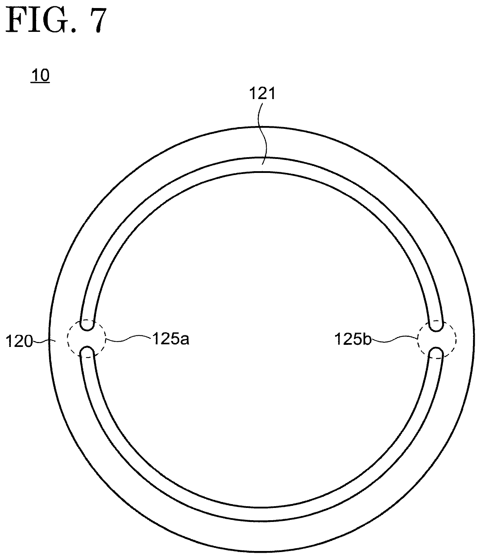

FIG. 5 is a schematic cross-sectional view showing a configuration of the heat insulating portion 150 of the stage 10 according to an embodiment of the present invention. Each of FIGS. 6 and 7 is a schematic plan view showing a configuration of the second metal plate 120 of the stage 10 according to an embodiment of the present invention. Specifically, each of FIGS. 6 and 7 is a top view of the second metal plate 120.

As shown in FIG. 5, the heat insulating portion 150 includes a first groove 111 formed in the first metal plate 110, a through hole 121 formed in the second metal plate 120, and a second groove 131 formed in the third metal plate 130. The first groove 111, the through hole 121, and the second groove 131 overlap each other. The first groove 111 has an opening surface on the side of the second metal plate 120. The through hole 121 penetrates the second metal plate 120 and has opening surfaces on the side of first metal plate 110 and on the side of the third metal plate 130. The second groove 131 has an opening surface on the side of the second metal plate 120. The opening surface of the first groove 111 approximately coincides with the opening surface of one end of the through hole 121, and the opening surface of the second groove 131 approximately coincides with the opening surface of the other end of the through hole 121. That is, the heat insulating portion 150 has a structure in which the first groove 111, the through hole 121, and the second groove 131 are connected to one another. In other words, the heat insulating portion 150 has a closed space that penetrates the second metal plate 120, has an upper surface formed in the first metal plate 110, and has a bottom surface formed in the third metal plate. The heat insulating portion 150 may be in a vacuum or may be filled with a liquid or gas. Further, the heat insulating portion 150 may be connected to an external vacuum pump or the like to adjust the pressure, temperature, or gas flow rate. An inert gas such as helium gas, argon gas, or nitrogen gas may be used as the gas filled in the heat insulating portion 150 or circulating in the heat insulating portion 150. Furthermore, the heat insulating portion 150 may be filled with a heat insulating material.

In a plan view, the first groove 111, the through hole 121, and the second groove 131 are formed circumferentially in the first metal plate 110, the second metal plate 120, and the third metal plate 130, respectively. As shown in FIG. 6, the through hole 121 is also provided circumferentially in the second metal plate 120. That is, the inner region and the outer region are separated in the second metal plate 120. In this case, the second metal plate 120 is arranged so that the separated inner region and outer region of the second metal plate 120 are not in contact with each other when the second metal plate 120 is bonded to the first metal plate 110 or the third metal plate 130, and is bonded to the first metal plate 110 or the third metal plate 130. However, when the through hole 121 formed in the second metal plate 120 is provided over the entire circumference so as to separate the inner region of the second metal plate 120 from the outer region, it may be difficult to handle the second metal plate 120 when bonding the second metal plate 120. Therefore, as shown in FIG. 7, the second metal plate 120 may be provided with connection regions 125a and 125b that connect the inner region and the outer region. Since the connection regions 125a and 125b can be a heat conduction path, it is preferable that the widths of the connection regions 125a and 125b are as small as possible. Further, although two connection regions 125a and 125b are shown in FIG. 7, it is sufficient that the second metal plate 120 is provided with at least one connection region 125. The number of connection regions 125 corresponds to the number of through holes 121. For example, when the second metal plate 120 is provided with three connection regions 125, the second metal plate 120 has three through holes 121.

Further, each of the first groove 111 and the second groove 131 may also be divided into a plurality of grooves.

The first groove 111 is provided between the circulating flow path 112 and the heater 113. In other words, the heat insulating portion 150 is located between the circulating flow path 112 in the inner region and the heater 113 in the outer region. The heat insulating portion 150 is provided across the first metal plate 110, the second metal plate 120, and the third metal plate 130, and has a large space. Therefore, the heat insulating portion 150 can suppress heat conduction from the inner region to the outer region and heat conduction from the outer region to the inner region not only in the first metal plate 110 but also in the second metal plate 120 and the third metal plate 130. Thus, a large temperature difference between the inner region and the outer region can be achieved in the stage 10.

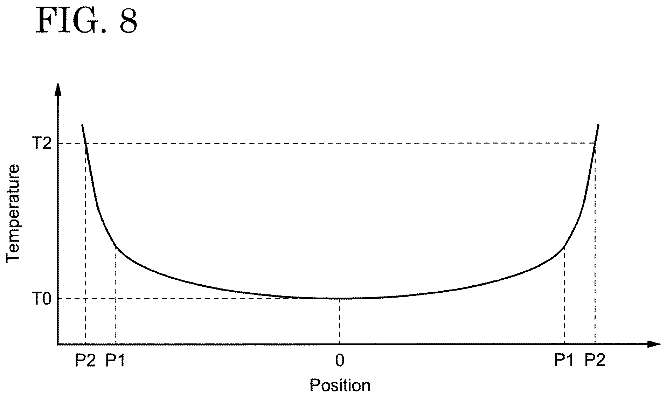

FIG. 8 is a graph illustrating a temperature gradient profile of the stage 10 according to an embodiment of the present invention.

In FIG. 8, the horizontal axis indicates the position of the surface of the first metal plate 110 along a predetermined direction (for example, the direction of the line A1-A2) with the center position of the surface of the first metal plate 110 being zero, and the vertical axis indicates the surface temperature of the surface of the first metal plate 110. The first position P1 and the second position P2 represent the positions of the heat insulating portion 150 and the heater 113, respectively. That is, the region between the two P1s corresponds to the inner region, and the region between the P1 and the P2 corresponds to the outer region.

In the stage 10, the inner region of the first metal plate 110 is cooled by the cooling medium flowing through the circulating flow path 112 in the inner region of the first metal plate 110. Meanwhile, the outer region of the first metal plate 110 is heated by the heater 113 in the outer region of the first metal plate 110. The heat of the outer region of the first metal plate 110 is conducted to the inner region. However, since the heat insulating portion 150 is provided between the inner region and the outer region, the heat conduction path between the inner region and the outer region is restricted, and the heat conduction from the outer region to the inner region is suppressed. Therefore, even when the outer region is heated by the heater 113, the temperature rise in the inner region is suppressed. Further, the temperature difference between the inner region and the outer region increases due to the reduction in the heat flow rate caused by the heat insulating portion 150. For example, the maximum temperature difference between the minimum surface temperature T0 measured near the center of the first metal plate 110 and the maximum surface temperature T2 measured near the heater 113 is higher than or equal to 20°C, preferably greater than or equal to 60°C, and more preferably greater than or equal to 100°C. The temperature difference between the inner region and the outer region of the stage 10 can be adjusted by changing the power supplied to the heater 113 or the conditions of the cooling medium flowing through the circulating flow path 112.

A flow path (not shown in the figures) through which the cooling medium flows is formed inside the shaft portion 200. Specifically, the shaft portion 200 feeds the cooling medium to the inlet 112a through a flow path and receives the cooling medium discharged from the outlet 112b. One end of the shaft portion 200 is connected to the second surface 102 of the plate portion 100. The other end of the shaft portion 200 is connected to a supply source of the cooling medium. For example, although the supply source may be a tank and pump that hold the cooling medium, or a water pipe, the supply source is not limited thereto.

Further, a lead wire of the heater 113 may be stored inside the shaft portion 200. Furthermore, in the case where an electrostatic chuck is provided, a wiring connected to the electrostatic chuck may be stored inside the shaft portion 200.

Moreover, the shaft portion 200 may be connected to a rotation mechanism. When the shaft portion 200 is connected to the rotation mechanism, the stage 10 can be rotated around the major axis of the shaft portion 200.

Although the configuration of the stage 10 is described above, the advantages of the stage 10 compared to a conventional stage are described in the following description.

In the process of the semiconductor apparatus, the wafer placed on the stage may be heated, and in that case, it is required to make the temperature distribution in the wafer uniform. In the conventional stage, the temperature of the outer region may be lower than that of the inner region when heated. Further, the temperature of the inner region of the wafer placed on the stage may increase, depending on the semiconductor apparatus. For example, when a film is deposited on a wafer in a CVD (Chemical Vapor Deposition) apparatus or an ALD (Atomic Layer Deposition) apparatus, the application of plasma causes a local temperature increase in the center of the wafer, and the temperature of the inner region of the wafer becomes higher than that of the outer region of the wafer. Therefore, a significant temperature drop is observed in the outer region of the wafer in the conventional stage.

On the other hand, in a semiconductor apparatus using the stage 10, the temperature difference between the inner region and the outer region of the stage 10 is large, and the significant temperature drop described above can be corrected to uniformize the temperature distribution in the wafer. In particular, since the stage 10 can obtain a temperature difference larger than the temperature difference at which cracks occur due to ceramics, the stage 10 can be applied to more semiconductor apparatuses than the stage using ceramics.

However, the thermal expansion coefficient of the metal or alloy contained in the first metal plate 110 to the fourth metal plate 140 is relatively larger than that of ceramic. Therefore, in the conventional stage in which the heat insulating portion 150 is not provided and the temperature difference between the inner region and the outer region is increased by simply controlling the circulating flow path 112 and the heater 113, the stage may be deformed by thermal stress. In other words, in the case of the conventional stage in which the heat insulating portion 150 is not provided, the stage is deformed by thermal stress, so that the temperature difference between the inner region and the outer region of the stage cannot be increased. Meanwhile, since the space of the heat insulating portion 150 contracts or expands in the stage 10, the thermal stress is relaxed. That is, the heat insulating portion 150 functions as a damper that absorbs the thermal stress caused by the temperature difference between the inner region and the outer region of the stage 10. Further, the heat insulating portion 150 is provided across the first metal plate 110, the second metal plate 120, and the third metal plate 130 in the stage 10. As a result, in the stage 10, not only the thermal stress in the first metal plate 110 in which the heater 113 is provided, but also the thermal stress in the third metal plate 130 to which the heat from the heater 113 is conducted is relaxed, so that the stage 10 is less likely to deform even when the temperature difference between the inner region and the outer region is increased.

Further, even when thermal stress greater than the yield stress is applied to the first metal plate 110 due to the elastic-plastic property of the metal, the heat insulating portion 150 deforms and functions as a damper, thereby suppressing further deformation of the first metal plate 110.

As described above, the heat insulating portion 150 can suppress the heat from the heater 113 provided in the outer region from being conducted to the inner region in the stage 10. That is, since the cross-sectional area of the heat conduction path connecting the outer region and the inner region of the plate portion 100 is reduced by the space formed by the heat insulating portion 150, the heat insulating portion 150 can function as a thermal blockage / thermal choke. As a result, since the temperature difference between the inner region and the outer region becomes large in the stage 10, the temperature of the outer region of the wafer can be corrected and the temperature distribution in the wafer can be made uniform, for example, when the stage 10 is applied to the wafer in which the temperature drop in the outer region is significant.

Several modifications of the stage 10 according to an embodiment of the present invention are described in the following description. In addition, the modifications of the configuration of the stage 10 are not limited to the modifications described below.

### <Modification 1>

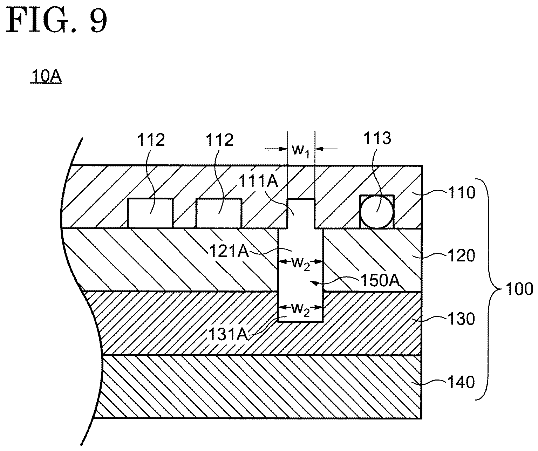

A modification of the stage 10 according to an embodiment of the present invention is described with reference to FIG. 9. In addition, a description of a configuration that is the same as or similar to the configuration of the stage 10 may be omitted in the following description.

FIG. 9 is a schematic cross-sectional view showing a configuration of a heat insulating portion 150A of a stage 10A according to an embodiment of the present invention.

As shown in FIG. 9, the insulating portion 150A includes a first groove 111A formed in the first metal plate 110, a through hole 121A formed in the second metal plate 120, and a second groove 131A formed in the third metal plate 130.

The first groove 111A has a first width w₁. The through hole 121A and the second groove 131A each have a second width w₂. The first width w₁ is smaller than the second width w₂. Therefore, although the side surface of the second groove 131A and the side surface of the through hole 121A coincide with each other, the side surface of the first groove 111A and the side surface of the through hole 121A do not coincide with each other. In addition, one of the side surfaces of the first groove 111A may coincide with the side surface of the through hole 121A.

### <Modification 2>

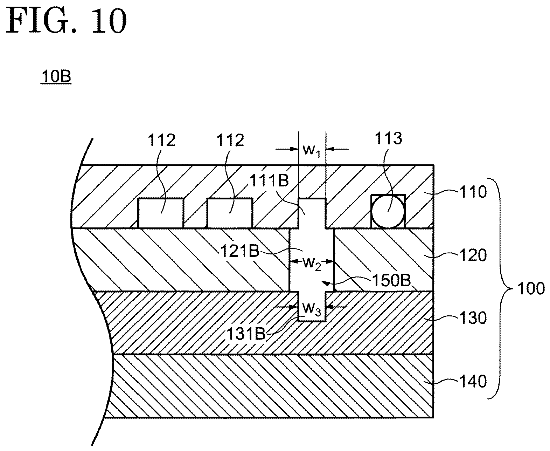

Another modification of the stage 10 according to an embodiment of the present invention is described with reference to FIG. 10. In addition, a description of a configuration that is the same as or similar to the configuration of the stage 10 or stage 10A may be omitted in the following description.

FIG. 10 is a schematic cross-sectional view showing a configuration of a heat insulating portion 150B of a stage 10B according to an embodiment of the present invention.

As shown in FIG. 10 , the insulating portion 150B includes a first groove 111B formed in the first metal plate 110, a through hole 121B formed in the second metal plate 120, and a second groove 131B formed in the third metal plate 130.

The first groove 111B has a first width w₁. The through hole 121B has a second width w₂. The second groove 131B has a third width w₃. Each of the first width w₁ and the third width w₃ is smaller than the second width w₂. The first width w₁ may be the same as the third width w₃, may be larger than the third width w₃, or may be smaller than the third width w₃. Therefore, the side surfaces of the first groove 111B and the second groove 131B do not coincide with the side surface of the through hole 121B. In addition, one of the side surfaces of the first groove 111B or the second groove 131B may coincide with the side surface of the through hole 121B.

### <Modification 3>

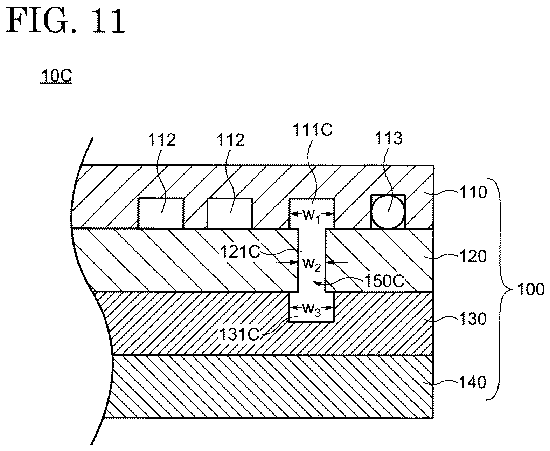

Another modification of the stage 10 according to an embodiment of the present invention is described with reference to FIG. 11. In addition, a description of a configuration that is the same as or similar to the configurations of the stages 10 to 10B may be omitted in the following description.

FIG. 11 is a schematic cross-sectional view showing a configuration of a heat insulating portion 150C of a stage 10C according to an embodiment of the present invention.

As shown in FIG. 11, the insulating portion 150C includes a first groove 111C formed in the first metal plate 110, a through hole 121C formed in the second metal plate 120, and a second groove 131C formed in the third metal plate 130.

The first groove 111C has a first width w₁. The through hole 121C has a second width w₂. The second groove 131C has a third width w₃. Each of the first width w₁ and the third width w₃ is larger than the second width w₂. The first width w₁ may be the same as the third width w₃, may be larger than the third width w₃, or may be smaller than the third width w₃. Therefore, the side surfaces of the first groove 111C and the second groove 131C do not coincide with the side surface of the through hole 121C. In addition, one of the side surfaces of the first groove 111C or the second groove 131C may coincide with the side surface of the through hole 121C.

### <Modification 4>

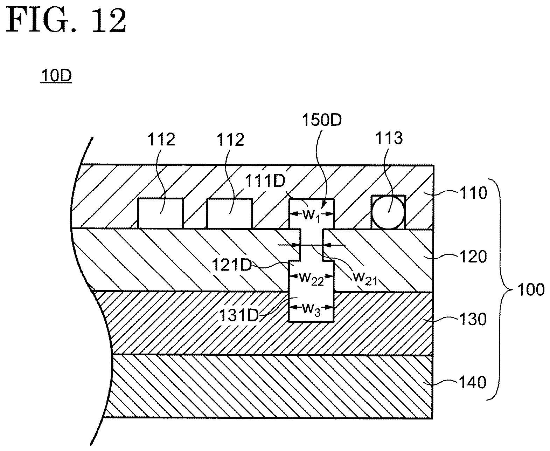

Another modification of the stage 10 according to an embodiment of the present invention is described with reference to FIG. 12. In addition, a description of a configuration that is the same as or similar to the configuration of the stage 10 to 10C may be omitted in the following description.

FIG. 12 is a schematic cross-sectional view showing a configuration of a heat insulating portion 150D of a stage 10D according to an embodiment of the present invention.

As shown in FIG. 12, the insulating portion 150D includes a first groove 111D formed in the first metal plate 110, a through hole 121D formed in the second metal plate 120, and a second groove 131D formed in the third metal plate 130.

The first groove 111D has a first width w₁. The through hole 121D has a second-1 width w₂₁ and a second-2 width w₂₂ that is different from the second-1 width w₂₁. That is, a step is formed in the through hole 121D. The second groove 131D has a third width w₃.

In the heat insulating portion 150D shown in FIG. 12, the second-1 width w₂₁ is smaller than the second-2 width w₂₂. However, the configuration of the heat insulating portion 150D is not limited thereto. The second-1 width w₂₁ may be larger than the second-2 width w₂₂. Further, the through hole 121D of the heat insulating portion 150D may have three widths. Furthermore, the first groove 111D or the second groove 131D of the heat insulating portion 150D may have two or more widths.

As described above in the Modifications 1 to 4, the width of the first groove 111, the width of the through hole 121, and the width of the second groove 131 are adjusted to form the heat insulating portion 150 having various cross-sectional shapes in the stage 10 according to an embodiment of the present invention. For example, the width of the first groove 111 is made larger than the widths of the through hole 121 and the second groove, and the space in the first metal plate 110 of the heat insulating portion 150 is made larger. Thus, the heat conduction path from the outer region to the inner region of the first metal plate 110 is reduced, and the temperature difference between the inner region and the outer region of the stage 10 can be increased. Further, for example, when the thermal conductivity of the second metal plate 120 is larger than that of the first metal plate 110, the width of the through hole 121 is made larger than the width of the first groove. In this case, heat from the heater 113 is easily conducted to the second metal plate 120. When the space in the second metal plate 120 of the heat insulating portion 150 is made larger, the heat conduction path from the outer region to the inner region of the second metal plate 120 is reduced, and the temperature difference between the inner region and the outer region of the stage 10 can be increased. In this manner, the width of the first groove 111, the width of the through hole 121, and the width of the second groove 131 can be adjusted in consideration of the heat conduction path from the outer region to the inner region of the stage 10.

### <Second Embodiment>

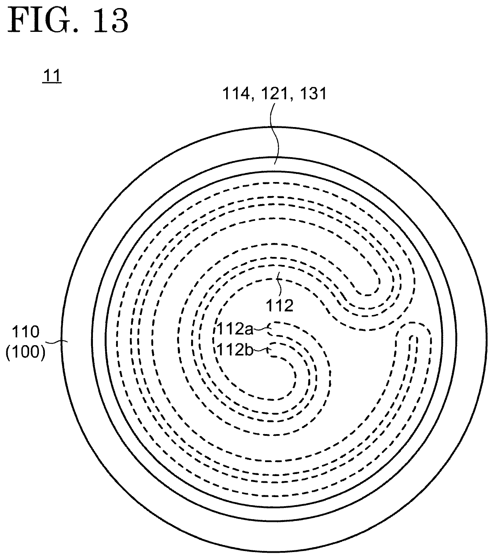

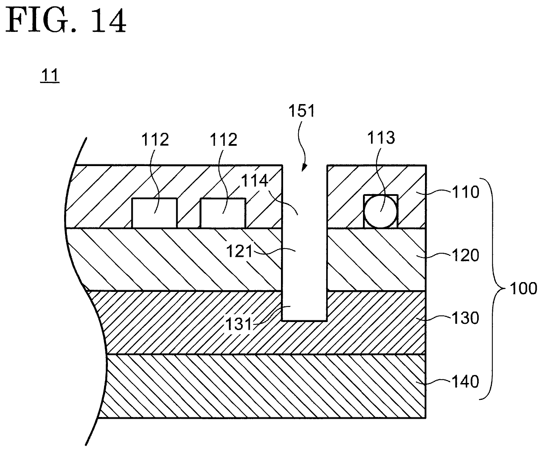

A stage 11 according to an embodiment of the present invention is described with reference to FIGS. 13 and 14. In addition, a description of a configuration that is the same as or similar to the configuration of the stage 10 may be omitted in the following description.

FIG. 13 is a schematic top view showing a configuration of the stage 11 according to an embodiment of the present invention. FIG. 14 is a schematic cross-sectional view showing the configuration of the stage 11 according to an embodiment of the present invention.

As shown in FIG. 14, the stage 11 includes the plate portion 100 in which the first metal plate 110 including a first through hole 114 formed therein, the second metal plate 120 including a second through hole 121 (corresponding to the through hole 121 in the First Embodiment) formed therein, the third metal plate 130 including a groove 131 (corresponding to the second groove 131 in the First Embodiment) formed therein, and the fourth metal plate 140 are stacked in order.

The first through hole 114, the second through hole 121, and the groove 131 overlap one another. The first through hole 114 penetrates the first metal plate 110 and has opening surfaces on the side of the first surface 101 of the stage 10 and on the side of the second metal plate 120. The opening surface at one end of the first through hole 114 is exposed in the first surface 101 of the stage 10, and the opening surface at the other end of the first through hole 114 approximately coincides with an opening surface at one end of the second through hole 121. That is, a heat insulating portion 151 has a structure in which the first through hole 114, the second through hole 121, and the groove 131 are connected to one another. In other words, the heat insulating portion 151 has a groove structure that penetrates the first metal plate 110 and the second metal plate 120 and has a bottom surface formed in the third metal plate 130.

In a plan view, the first through hole 114, the second through hole 121, and the groove 131 are formed in a circumferential shape on the first metal plate 110, the second metal plate 120, and the third metal plate 130, respectively (see FIG. 13). Although not shown in the figures, the first through hole 114 and the second through hole 121 may be provided with a connection region so that the inner region and the outer region are connected to each other as shown in FIG. 7. In this case, the connection region provided in the first metal plate 110 and the connection region provided in the second metal plate 120 may or may not overlap each other.

The inside of the heat insulating portion 151 may be exposed to air or may be filled with a liquid or a heat insulating material. In the stage 11, a part of the heat insulating portion 151 is exposed, and heat conduction from the outer region to the inner region of the plate portion 100 and heat conduction from the inner region to the outer region can be suppressed by releasing heat from the heat insulating portion 151 to the outside of the stage 11. Thus, the temperature difference between the inner region and the outer region can be increased in the stage 11.

As described above, the heat insulating portion 151 can function as a thermal blockage / thermal choke in the stage 11. Since the temperature difference between the inner region and the outer region is large in the stage 11, the temperature of the outer region of the wafer can be corrected and the temperature distribution in the wafer can be made uniform, for example, when the stage 11 is applied to the wafer in which the temperature drop in the outer region is significant.

Several modifications of the stage 11 according to an embodiment of the present invention are described in the following description. In addition, the modifications of the configuration of the stage 11 are not limited to the modifications described below.

### <Modification 1>

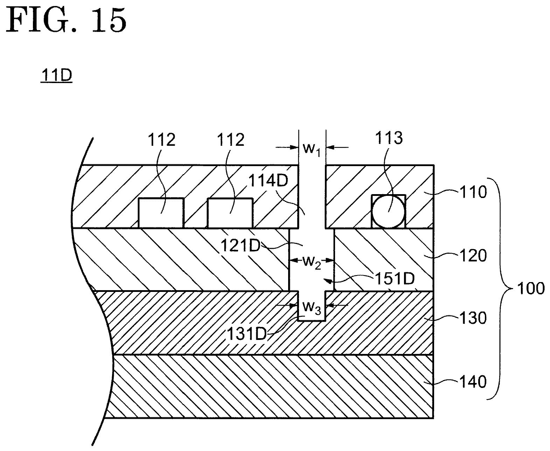

A modification of the stage 11 according to an embodiment of the present invention is described with reference to FIG. 15. In addition, a description of a configuration that is the same as or similar to the configuration of the stage 11 may be omitted in the following description.

FIG. 15 is a schematic cross-sectional view showing a configuration of a heat insulating portion 151D of a stage 11D according to an embodiment of the present invention.

As shown in FIG. 15, the insulation portion 151D includes a first through hole 114D formed in the first metal plate 110, a second through hole 121D formed in the second metal plate 120, and a groove 131D formed in the third metal plate 130.

The first through hole 114D has a first width w₁. The second through hole 121D has a second width w₂. The groove 131D has a third width w₃. Each of the first width w₁ and the third width w₃ is smaller than the second width w₂. The first width w₁ may be the same as the third width w₃, may be larger than the third width w₃, or may be smaller than the third width w₃. Therefore, the side surfaces of each of the first through hole 114D and the groove 131D do not coincide with the side surface of the second through hole 121D. In addition, one of the side surfaces of the first through hole 114D or the groove 131D may coincide with the side surface of the second through hole 121D.

### <Modification 2>

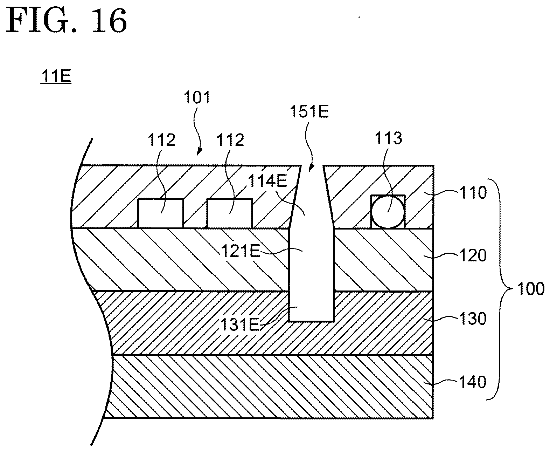

Another modification of the stage 11 according to an embodiment of the present invention is described with reference to FIG. 16. In addition, a description of a configuration that is the same as or similar to the configuration of the stage 11 or stage 11D may be omitted in the following description.

FIG. 16 is a schematic cross-sectional view showing a configuration of a heat insulating portion 151E of a stage 11E according to an embodiment of the present invention.

As shown in FIG. 16, the insulation portion 151E includes a first through hole 114E formed in the first metal plate 110, a second through hole 121E formed in the second metal plate 120, and a groove 131E formed in the third metal plate 130.

The opening diameter of the first through hole 114E gradually decreases from the second metal plate 120 toward the first surface 101 of the stage 11E (toward the surface of the first metal plate 110). In other words, the side surface of the first through hole 114E has a tapered shape.

In addition, the first through hole 114E may have a configuration opposite to the tapered shape of the first through hole 114E shown in FIG. 16. That is, the opening diameter of the first through hole 114E may gradually increase from the second metal plate 120 toward the first surface 101 of the stage 11E (toward the surface of the first metal plate). Further, the second through hole 121E and the groove 131E may have a tapered shape.

As described above in Modifications 1 and 2, the heat insulating portions 151 having various cross-sectional shapes can be formed in the stage 11 according to an embodiment of the present invention by adjusting the width of the first through hole 114, the width of the second through hole 121, the width of the groove 131, the tapered shape of the first through hole 114, the tapered shape of the second through hole 121, and the tapered shape of the groove 131.

### <Third Embodiment>

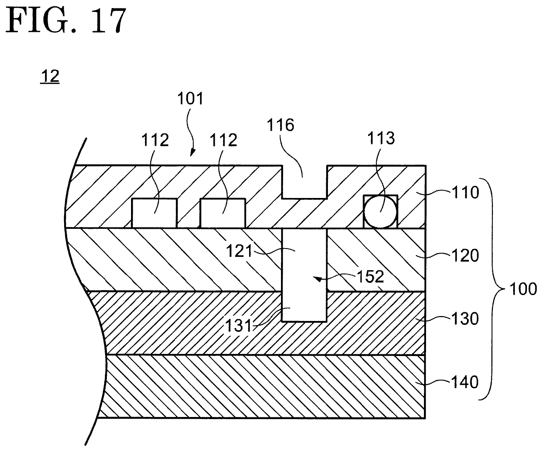

A stage 12 according to an embodiment of the present invention is described with reference to FIG. 17. In addition, a description of a configuration that is the same as or similar to the configuration of the stage 10 or the stage 11 may be omitted in the following description.

FIG. 17 is a schematic cross-sectional view showing a configuration of the stage 12 according to an embodiment of the present invention.

As shown in FIG. 17, the plate portion 100 of the stage 12 includes the first metal plate 110 including a first groove 116 formed therein, the second metal plate 120 including the through hole 121 formed therein, the third metal plate 130 including the second groove 131 formed therein, and the fourth metal plate 140.

The first groove 116, the through hole 121, and the second groove 131 overlap one another. The first groove 116 has an opening surface on the side of the first surface 101 of the stage 12. An opening surface at one end of the through hole 121 is closed by the first metal plate 110. An opening surface at the other end of the through hole 121 is approximately coincident with an opening surface of the second groove 131. That is, a heat insulating portion 152 has a structure in which the through hole 121 and the second groove 131 are connected to each other, and one end of the through hole 121 is closed by the first metal plate 110. Further, the first groove 116 is provided over the heat insulating portion 152 so as to overlap the heat insulating portion 152.

The inside of the heat insulating portion 152 may be a vacuum or may be filled with a liquid, a gas, or a heat insulating material. The inside of the first groove 116 may be exposed to air or may be filled with a liquid or a heat insulating material. Since the space formed by the heat insulating portion 152 reduces the heat conduction path connecting the outer region and the inner region of the plate portion 100 in the stage 12, the heat insulating portion 152 can function as a thermal blockage / thermal choke. Further, the heat conduction from the outer region to the inner region of the first metal plate 110 and from the inner region to the outer region can be suppressed by releasing heat from the first groove 116 to the outside of the stage 12. Thus, the temperature difference between the inner region and the outer region can be increased in the stage 12.

As described above, the heat insulating portion 152 and the first groove 116 can function as a thermal blockage / thermal choke in the stage 12. Since the temperature difference between the inner region and the outer region is large in the stage 12, the temperature of the outer region of the wafer can be corrected and the temperature distribution in the wafer can be made uniform, for example, when the stage 12 is applied to the wafer in which the temperature drop in the outer region is significant.

### <Fourth Embodiment>

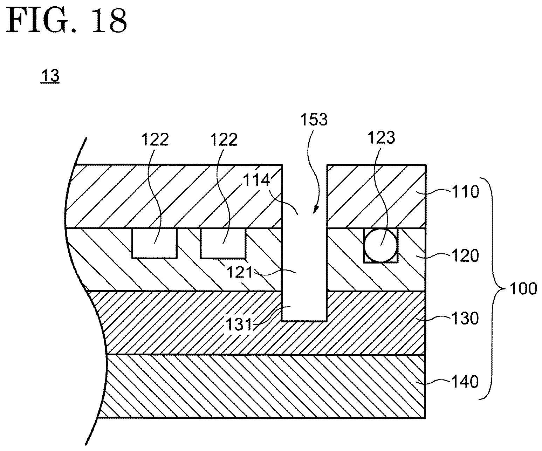

A stage 13 according to an embodiment of the present invention is described with reference to FIG. 18. In addition, a description of a configuration that is the same as or similar to the configuration of the stage 10 may be omitted in the following description.

FIG. 18 is a schematic cross-sectional view showing a configuration of the stage 13 according to an embodiment of the present invention.

As shown in FIG. 18, the stage 13 includes the plate portion 100 in which the first metal plate including the first through hole 114 formed therein, the second metal plate 120 including a second through hole 121 (corresponding to the through hole 121 in the First Embodiment) formed therein, the third metal plate 130 having a groove 131 (corresponding to the second groove 131 in the First Embodiment) formed therein, and the fourth metal plate 140 are stacked in order.

The first through hole 114, the second through hole 121, and the groove 131 overlap one another. The first through hole 114 penetrates the first metal plate 110 and has the opening surfaces on the side of the first surface 101 of the stage 10 and on the side of the second metal plate 120. The opening surface at one end of the first through hole 114 is exposed in the first surface 101 of the stage 10, and the opening surface at the other end of the first through hole 114 approximately coincides with the opening surface at one end of the second through hole 121. That is, a heat insulating portion 153 has a structure in which the first through hole 114, the second through hole 121, and the groove 131 are connected to one another. In other words, the heat insulating portion 153 has a groove structure that penetrates the first metal plate 110 and the second metal plate 120 and has a bottom surface formed in the third metal plate 130.

Further, in the stage 13, the second metal plate 120 is provided with a circulating flow path 122 and a heater 123 with a heat insulating portion 143 sandwiched therebetween. The circulating flow path 122 is provided on the side of the first metal plate 110 in the second metal plate 120 and is closed by the first metal plate 110. The heater 123 is also provided on the side of the first metal plate 110 in the second metal plate 120. Therefore, the inner region of the first metal plate 110 is cooled by the cooling medium flowing through the circulating flow path 122, and the outer region of the first metal plate 110 is heated by the heater 123. Since the heat insulating portion 150 is provided between the inner region and the outer region of the first metal plate 110, the heat conduction from the inner region to the outer region and from the outer region to the inner region is suppressed. Therefore, the temperature difference between the inner region and the outer region can be increased in the stage 13.

As described above, the heat insulating portion 153 can function as a thermal blockage / thermal choke in the stage 13. Since the temperature difference between the inner region and the outer region is large in the stage 13, the temperature of the outer region of the wafer can be corrected and the temperature distribution in the wafer can be made uniform, for example, when the stage 13 is applied to the wafer in which the temperature drop in the outer region is significant.

### <Fifth Embodiment>

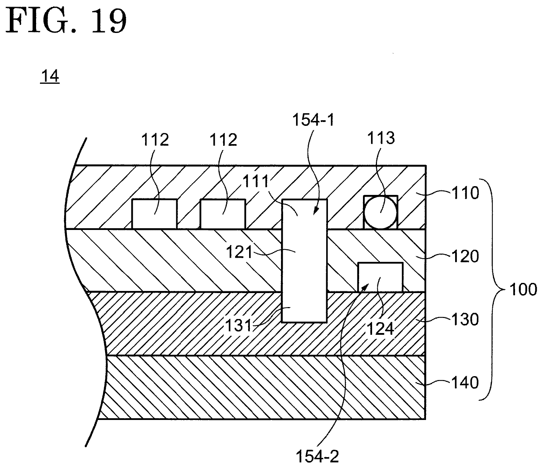

A stage 14 according to an embodiment of the present invention is described with reference to FIG. 19. In addition, a description of a configuration that is the same as or similar to the configuration of the stages 10 to 13 may be omitted in the following description.

FIG. 19 is a schematic cross-sectional view showing a configuration of a heat insulating portion 154 of the stage 14 according to an embodiment of the present invention.

As shown in FIG. 19, the stage 14 includes the plate portion 100 in which the first metal plate 110 including the first groove 111 formed therein, the second metal plate 120 including the through hole 121 and a second groove 124 formed therein, the third metal plate 130 including a third groove 131 (corresponding to the second groove 131 in the First Embodiment) formed therein, and the fourth metal plate 140 are stacked in order.

The first groove 111, the through hole 121, and the third groove 131 overlap one another in a plan view. That is, the stage 14 includes a first heat insulating portion 154-1 in which the first groove 111, the through hole 121, and the third groove 131 are connected to one another. Further, an opening surface of the second groove 124 is closed by the third metal plate 130. That is, the stage 14 includes a second heat insulating portion 154-2 formed by the second groove 124. The second heat insulating portion 154-2 overlaps the heater 113. The first heat insulating portion 154-1 and the second heat insulating portion 154-2 are not connected to each other. That is, the stage 14 includes a plurality of heat insulating portions 154.

The first heat insulating portion 154-1 can suppress heat conduction from the inner region to the outer region and from the outer region to the inner region. The second heat insulating portion 154-2 can suppress the heat generated by the heater 113 provided in the outer region from being conducted to the inner region through the third metal plate 130. Thus, the temperature difference between the inner region and the outer region in the stage 14 can be increased.

As described above, in the stage 14, the heat insulating portion 154 can suppress the heat from the heater 113 provided in the outer region from being conducted to the inner region. That is, since the cross-sectional area of the heat conduction path connecting the outer region and the inner region of the plate part 100 is reduced by the space formed by the plurality of heat insulating portions 154, the heat insulating portions 154 can function as a thermal blockage / thermal choke. Since the temperature difference between the inner region and the outer region is large in the stage 14, the temperature of the outer region of the wafer can be corrected and the temperature distribution in the wafer can be made uniform, for example, when the stage 14 is applied to a wafer in which the temperature drop in the outer region is significant.

Several modifications of the stage 14 according to an embodiment of the present invention are described in the following description. In addition, the modifications of the configuration of the stage 14 are not limited to the modifications described below.

### <Modification 1>

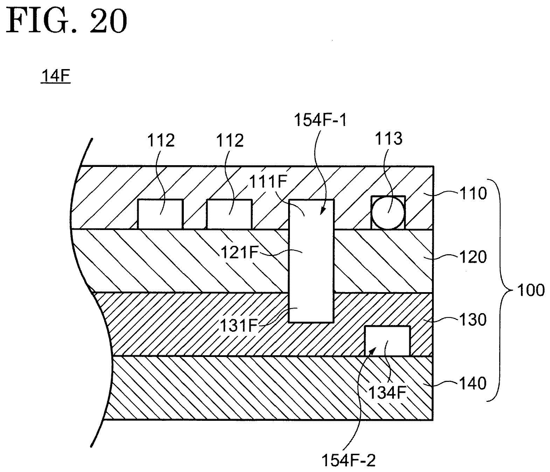

A modification of the stage 14 according to an embodiment of the present invention is described with reference to FIG. 20. In addition, a description of a configuration that is the same as or similar to the configuration of the stage 14 may be omitted in the following description.

FIG. 20 is a schematic cross-sectional view showing a configuration of a heat insulating portion 154F of a stage 14F according to an embodiment of the present invention.

As shown in FIG. 20, the stage 14F includes the plate portion 100 in which the first metal plate 110 including a first groove 111F formed therein, the second metal plate 120 including the through hole 121 formed therein, a third metal plate 130 including a second groove 131F and a third groove 134F formed therein, and the fourth metal plate 140 are stacked in order.

The first groove 111F, the through hole 121F, and the second groove 131F overlap one another in a plan view. That is, the stage 14F includes a first heat insulating portion 154F-1 in which the first groove 111F, the through hole 121F, and the second groove 131F are connected to one another. Further, an opening surface of the third groove 134F is closed by the fourth metal plate 140. That is, the stage 14F includes a second heat insulating portion 153-2 formed by the third groove 134F. The second heat insulating portion 154F-2 overlaps the heater 113. The first heat insulating portion 154F-1 and the second heat insulating portion 154-2 are not connected to each other. That is, the stage 14F includes a plurality of heat insulating portions 154F.

### <Modification 2>

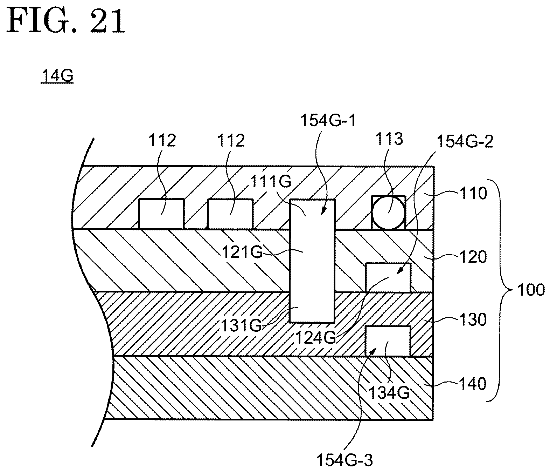

Another modification of the stage 14 according to an embodiment of the present invention is described with reference to FIG. 21. In addition, a description of a configuration that is the same as or similar to the stage 14 or stage 14F may be omitted in the following description.

FIG. 21 is a schematic cross-sectional view showing a configuration of a heat insulating portion 154G of a stage 14G according to an embodiment of the present invention.

As shown in FIG. 21, the stage 14G includes the plate portion 100 in which the first metal plate 110 including a first groove 111G formed therein, the second metal plate 120 including a through hole 121G and a second groove 124G formed therein, the third metal plate 130 including a third groove 131G and a fourth groove 134G formed therein, and the fourth metal plate 140 are stacked in order.

The first groove 111G, the through hole 121G, and the third groove 131G overlap one another in a plan view. That is, the stage 14G includes a first heat insulating portion 154G-1 in which the first groove 111G, the through hole 121G, and the third groove 131G are connected to one another. Further, an opening surface of the second groove 124G is closed by the third metal plate 130, and an opening surface of the fourth groove 134G is closed by the fourth metal plate 140. That is, the stage 14G includes a second heat insulating portion 154G-2 formed by the second groove 124G, and a third heat insulating portion 154G-3 formed by the fourth groove 134G. The second heat insulating portion 154G-2 and the third heat insulating portion 154G-3 overlap the heater 113. The first heat insulating portion 154FG-1, the second heat insulating portion 154G-2, and the third heat insulating portion 154G-3 are not connected to one another. That is, the stage 14G includes a plurality of heat insulating portions 154G.

### <Modification 3>

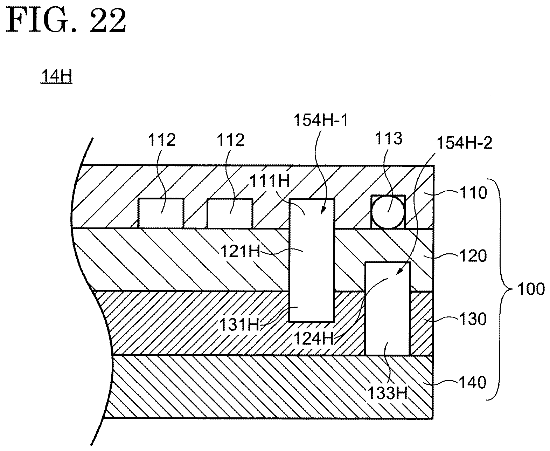

Another modification of the stage 14 according to an embodiment of the present invention is described with reference to FIG. 22. In addition, a description of a configuration that is the same as or similar to the stage 14 to 14G may be omitted in the following description.

FIG. 22 is a schematic cross-sectional view showing a configuration of a heat insulating portion 154H of a stage 14H according to an embodiment of the present invention.

As shown in FIG. 22, the stage 14H includes the plate portion 100 in which the first metal plate 110 including a first groove 111H formed therein, the second metal plate 120 including a first through hole 121G and a second groove 124H formed therein, the third metal plate 130 including a third groove 131H and a second through hole 133H formed therein, and the fourth metal plate 140 are stacked in order.

The first groove 111H, the first through-hole 121H, and the third groove 131H overlap one another in a plan view. That is, the stage 14H includes a first heat insulating portion 154H-1 in which the first groove 111G, the first through hole 121H, and the third groove 131H are connected to one another. Further, the second groove 124H is connected to the second through hole 133H, and one end of the second through hole 133H is closed by the fourth metal plate 140. That is, the stage 14H includes a second heat insulating portion 154H-2 formed by the second groove 124H and the second through hole 133H. The second heat insulating portion 154H-2 overlaps the heater 113. The first heat insulating portion 154H-1 and the second heat insulating portion 154H-2 are not connected to each other. That is, the stage 14H includes a plurality of heat insulating portions 154H.

As described above in the Modifications 1 to 3, grooves and through holes can be combined to form a plurality of heat insulating portions 154 in the stage 14 according to an embodiment of the present invention. In addition, although the configurations are described in which another heat insulating portion 154 other than the heat insulating portion 154 is formed as a boundary between the inner region and the outer region in the outer region in Modifications 1 to 3, the other heat insulating portion 154 may also be formed in the inner region.

### <Sixth Embodiment>

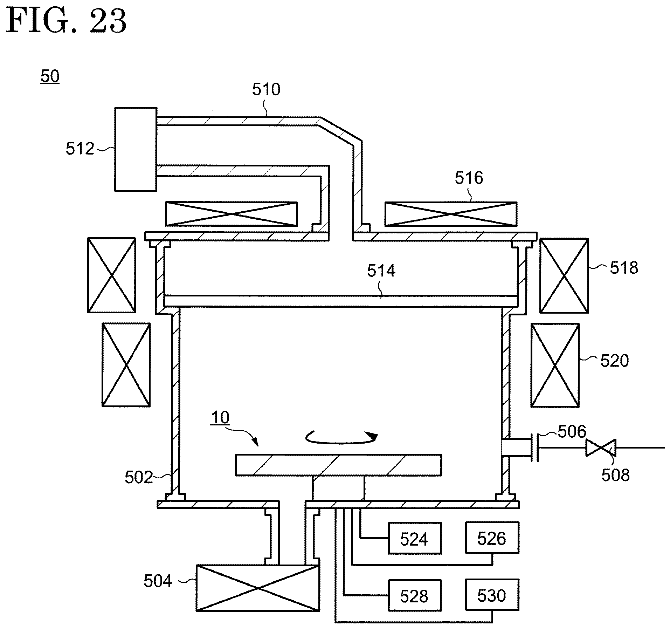

An etching apparatus 50 according to an embodiment of the present invention is described with reference to FIG. 23. The etching apparatus 50 includes the stage 10. Therefore, a description of the same or similar configuration as that of the stage 10 described in the First Embodiment may be omitted in the following description.

FIG. 23 is a schematic cross-sectional view showing a configuration of the etching apparatus 50 according to an embodiment of the present invention.

The etching apparatus 50 can perform dry etching on various films. The etching apparatus 50 includes a chamber 502. The chamber 502 supplies a space to perform etching on a film of a conductor, an insulator, or a semiconductor formed on a wafer.

An exhaust device 504 is connected to the chamber 502, by which the inside of the chamber 502 can be set under a reduced-pressure atmosphere. The chamber 502 is further provided with an inlet tube 506 for introducing a reaction gas which is supplied to the chamber 502 through a valve 508. For example, a fluorine-containing organic compound such as tetrafluorocarbon (CF₄), octafluorocyclobutane (*c*-C₄F₈), decafluorocyclopentane (*c*-C₅F₁₀), hexafluorobutadiene (C₄F₆) is used as the reaction gas.

A microwave source 512 may be provided at an upper portion of the chamber 502 through a waveguide tube 510. The microwave source 512 has an antenna and the like for supplying a microwave and outputs a high-frequency microwave such as a microwave of 2.45 GHz and a radio wave (RF) of 13.56 MHz. The microwave generated by the microwave source 512 is transmitted to the upper portion of the chamber 502 with the waveguide tube 510 and then introduced into the chamber 502 through a window 514 including quartz, ceramic, or the like. The reaction gas is plasmatized with the microwave, and the etching proceeds with electrons, ions, and radicals included in the plasma.

The stage 10 for placing a wafer is provided at a lower portion of the chamber 502. A power source 524 is connected to the stage 10, and high-frequency electric power is supplied to the stage 10, thereby forming an electric field in a direction perpendicular to the surfaces of the stage 10 and the wafer with the microwave. Magnets 516, 518, and 520 may be provided at the upper portion and on a side surface of the chamber 502. The magnets 516, 518, and 520 may each be a permanent magnet or an electromagnet having an electromagnetic coil. A magnetic component parallel to the surfaces of the stage 10 and the wafer is generated with the magnets 516, 518, and 520. The electrons in the plasma resonate upon receiving a Lorentz force in association with the electrical field generated by the microwave and are bound on the surfaces of the stage 10 and the wafer. Accordingly, a high-density plasma can be generated on the surface of the wafer.

A heater power source 530 for controlling the heater 113 provided to the stage 10 is connected to the stage 10. As an optional structure, a power source 526 for an electrostatic chuck for fixing the wafer to the stage 10, a temperature controller 528 for controlling the temperature of a medium circulated in the stage 10, and a rotation-controlling device (not shown in the figures) for rotating the stage 10 may be further connected to the stage 10.

### <Seventh Embodiment>

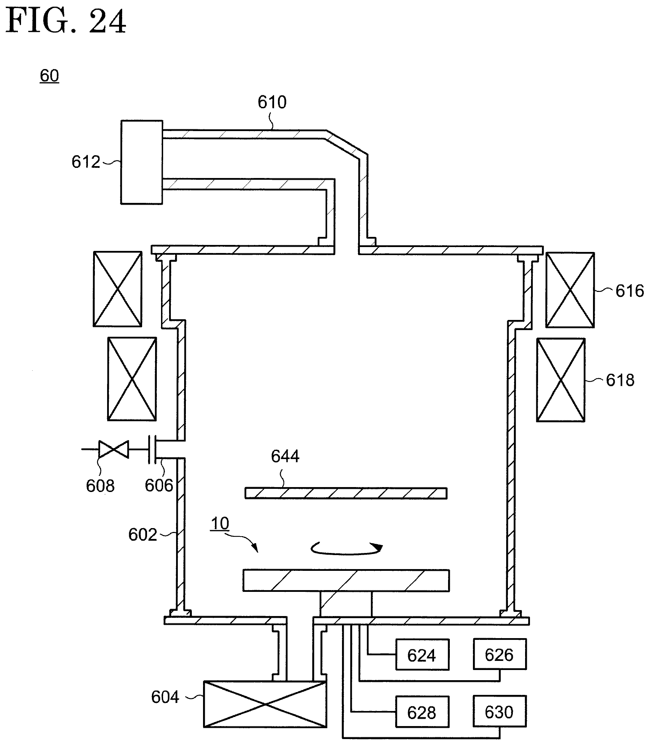

A CVD apparatus 60 according to an embodiment of the present invention is described with reference to FIG. 24. The CVD apparatus 60 includes the stage 10. Therefore, a description of the same or similar configuration as that of the stage 10 described in the First Embodiment may be omitted in the following description.

FIG. 24 is a schematic cross-sectional view showing a configuration of the CVD apparatus 60 according to an embodiment of the present invention.

The CVD apparatus 60 includes a chamber 602. The CVD apparatus 60 provides a space for chemically reacting a reaction gas to form various films on a wafer.

An exhaust apparatus 604 is connected to the chamber 602, by which the pressure in the chamber 602 can be reduced. The chamber 602 is further provided with an inlet tube 606 for introducing the reaction gas, and the reaction gas for film formation is introduced into the chamber 602 through a valve 608. As the reaction gas, a variety of gases can be used depending on the films to be formed. The gas may be a liquid at a normal temperature. For example, thin films of silicon, silicon oxide, silicon nitride, and the like can be prepared using silane, dichlorosilane, tetraethoxysilane, and the like. Further, metal films of tungsten, aluminum, and the like can be prepared using tungsten fluoride, trimethylaluminum, and the like.

Similar to the etching apparatus 50, a microwave source 612 may be provided at an upper portion of the chamber 602 through a waveguide tube 610. A microwave generated with the microwave source 612 is introduced into the chamber 602 with the waveguide tube 610. The reaction gas is plasmatized with the microwave, and the chemical reaction of the gas is promoted by a variety of active species included in the plasma. Products obtained by the chemical reactions are deposited over a wafer, resulting in a thin film. As an optional element, a magnet 644 may be provided in the chamber 602 in order to increase plasma density. The stage 10 is disposed at a lower portion of the chamber 302, which enables deposition of a thin film in a state where a wafer is placed over the stage 10. Similar to the etching apparatus 50, magnets 616 and 618 may be further provided on a side surface of the chamber 602.

A heater power source 630 for controlling the heater 113 provided in the stage 10 is further connected to the stage 10. As an optional element, a power source 624 for supplying a high-frequency electric power to the stage 10, a power source 626 for an electrostatic chuck, a temperature controller 628 for temperature control of a cooling medium circulated in the stage 10, or a rotation-controlling device (not shown in the figures) for rotating the stage 10, and the like may be connected to the stage 10.

### <Eighth Embodiment>

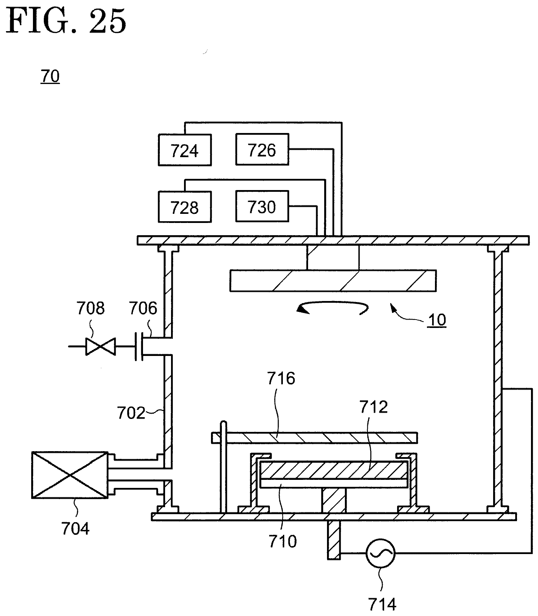

A sputtering apparatus 70 according to an embodiment of the present invention is described with reference to FIG. 25. The sputtering apparatus 70 includes the stage 10. Therefore, a description of the same or similar configuration as that of the stage 10 described in the Second Embodiment may be omitted in the following description.

FIG. 25 is a schematic cross-sectional view showing a configuration of the sputtering apparatus 70 according to an embodiment of the present invention.

The sputtering apparatus 70 includes a chamber 702. The sputtering apparatus 70 provides a space for collision of high-speed ions with a target and deposition of target atoms generated by the collision on a wafer.

An exhaust apparatus 704 for reducing pressure in the chamber 702 is connected to the chamber 702. An inlet tube 706 for supplying a sputtering gas such as argon into the chamber 702 and a valve 708 are provided to the chamber 702.

A target stage 710 for supporting a target containing a material to be deposited and functioning as a cathode is arranged at a lower portion of the chamber 702, over which the target 712 is provided. A high-frequency power source 714 is connected to the target stage 710, and plasma can be generated in the chamber 702 with the high-frequency power source 714.

The stage 10 may be disposed at an upper portion of the chamber 702. In this case, film-formation proceeds in the state where the wafer is placed under the stage 10. Similar to the etching apparatus 50 and the CVD apparatus 60, a heater-power source 730 is connected to the stage 10. A power source 724 for supplying a high-frequency electric power to the stage 10, a power source 726 for an electrostatic chuck, a temperature controller 728, and a rotation-controlling device (not shown in the figures) for rotating the stage 10 may be connected to the stage 10.

Argon ions accelerated with the plasma generated in the chamber 702 collide with the target 712, and the atoms of the target 712 are sputtered. The sputtered atoms fly to the wafer placed under the stage 10 while a shutter 716 is opened and are deposited.

In FIG. 25, the configuration is exemplified in which the stage 10 and the target stage 710 are respectively disposed at the upper portion and the lower portion of the chamber 702. However, the sputtering apparatus 70 is not limited to this configuration, and the sputtering apparatus 70 may be configured so that the target 712 is positioned over the stage 10. Alternatively, the stage 10 may be disposed so that a main surface of the wafer is arranged perpendicular to the horizontal plane, and the target stage 710 may be provided so as to face the stage 10.

### <Ninth Embodiment>

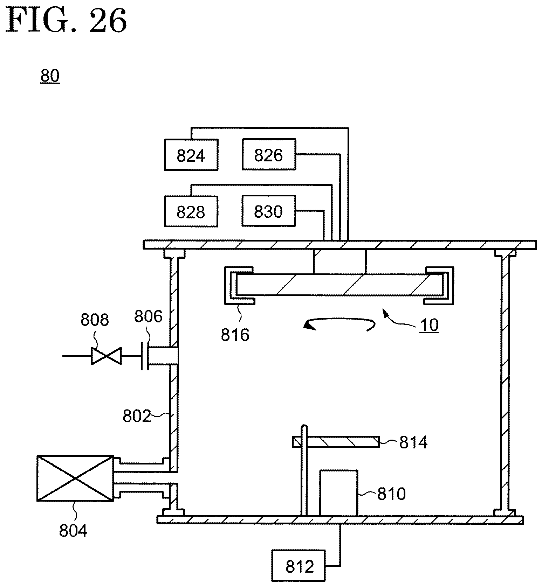

An evaporation apparatus 80 according to an embodiment of the present invention is described with reference to FIG. 26. The evaporation apparatus 80 includes the stage 10. Therefore, a description of the same or similar configuration as that of the stage 10 described in the First Embodiment may be omitted in the following description.

FIG. 26 is a schematic cross-sectional view showing a configuration of the evaporation apparatus 80 according to an embodiment of the present invention.

The evaporation apparatus 80 includes a chamber 802. The chamber 802 provides a space for evaporating a material in an evaporation source 810 and depositing the evaporated material over a wafer.

An exhaust apparatus 804 for making the inside of the chamber 802 a high vacuum is connected to the chamber 802. An inlet tube 806 for returning the inside of the chamber 802 to an atmospheric pressure is provided to the chamber 802, and an inert gas such as nitrogen and argon is introduced into the chamber 802 through a valve 808.

The stage 10 may be disposed at an upper portion of the chamber 802. Deposition of the material proceeds in a state where the wafer is placed under the stage 10. Similar to the etching apparatus 50, the CVD apparatus 60, and the sputtering apparatus 70, a heater-power source 828 is connected to the stage 10. As an optional structure, a power source 824 for an electrostatic chuck, a temperature controller 826, and a rotation-controlling device 830 for rotating the stage 10 may be connected to the stage 10. The stage 10 may further include a mask holder 816 for fixing a metal mask between the wafer and the evaporation source 610. With this structure, it is possible to arrange the metal mask at a vicinity of the wafer so that an opening portion of the metal mask overlaps a region where the material is to be deposited.

The evaporation source 810 is provided at a lower portion of the chamber into which the material subjected to evaporation is charged. A heater for heating the material is provided to the evaporation source 810, and the heater is controlled with a controlling device 812. The inside of the chamber 802 is made a high vacuum using the exhaust apparatus 804, and the material is vaporized by heating the evaporation source 810 to start evaporation. A shutter 814 is opened when an evaporation rate becomes constant, by which deposition of the material is started over the wafer.

The stage 10 is used in the etching apparatus 50, the CVD apparatus 60, the sputtering apparatus 70, and the evaporation apparatus 80 described in the Sixth to Ninth Embodiments. When the stage 10 is used, the temperature distribution in the wafer in which the temperature drop in the outer region is significant can be made uniform.

Each of the embodiments described above as the embodiments of the present invention can be appropriately combined and implemented as long as no contradiction is caused. Further, the addition, deletion, or design change of components, or the addition, deletion, or condition change of processes as appropriate by those skilled in the art based on each of embodiments are also included in the scope of the present invention as long as they are provided with the gist of the present invention.

Further, it is understood that, even if the effect is different from those provided by each of the above-described embodiments, the effect obvious from the description in the specification or easily predicted by persons ordinarily skilled in the art is apparently derived from the present invention.

### REFERENCES SIGN LIST

10, 11, 12: stage, 50: etching apparatus, 60: CVD apparatus, 70: sputtering apparatus, 80: evaporation apparatus, 100: plate portion, 101: first surface, 102: second surface, 110: first metal plate, 111: groove, 112: circulating flow path, 112a: inlet, 112b: outlet, 113: heater, 114: through hole, 116: groove, 120: second metal plate, 121: through hole, 122: circulating flow path, 123: heater 124: groove, 125: connection region, 125a, 125b: connection region, 130: third metal plate, 131: groove, 133: through hole, 134: groove, 140: fourth metal plate, 150, 151, 152, 153, 154: heat insulating portion, 200: shaft portion, 502: chamber, 504: exhaust device, 506: inlet tube, 508: valve, 510: waveguide tube, 512: microwave source, 514: window, 516, 518, 520: magnet, 524, 526: power source, 528: temperature controller, 530: heater power source, 602: chamber, 604: exhaust device, 606: inlet tube, 608: valve, 610: waveguide, 612: microwave source, 616, 618: magnet, 624, 626: power source, 628: temperature controller, 630: heater power source, 644: magnet, 702: chamber , 704: exhaust device, 706: inlet tube, 708: valve, 710: target stage, 712: target, 714: high frequency power source, 716: shutter, 724, 726: power source, 728: temperature controller, 730: heater power source, 802: chamber, 804: exhaust device, 806: inlet tube, 808: valve, 810: evaporation source, 812: controlling device, 814: shutter, 816: mask holder, 824: power source, 826: temperature controller, 828: heater power source, 830: rotation-controlling device

## Claims

1. A stage, comprising:
a first metal plate;
a second metal plate below the first metal plate;
a heat insulating portion comprising a first space provided in the first metal plate and a second space provided in the second metal plate; and
a circulating flow path and a heater with the heat insulating portion interposed therebetween,
wherein in a cross-sectional view, a width of the heat insulating portion in the first metal plate is different from a width of the heat insulating portion in the second metal plate.

2. A stage, comprising:
a first metal plate comprising a first groove;
a second metal plate comprising a through hole, below the first metal plate;
a third metal plate comprising a second groove, below the second metal plate; and
a circulating flow path and a heater with the first groove interposed therebetween,
wherein the first groove, the through hole, and the second groove are connected to one another.

3. The stage according to claim 2, wherein in a cross-sectional view, a width of the first groove is different from a width of at least one of the through hole and the second groove.

4. A stage, comprising:
a first metal plate comprising a first through hole;
a second metal plate comprising a second through hole, below the first metal plate;
a third metal plate comprising a groove, below the second metal plate; and
a circulating flow path and a heater with the first through hole interposed therebetween,
wherein the first through hole, the second through hole, and the groove are connected to one another.

5. The stage according to claim 4, wherein in a cross-sectional view, a width of the first through hole is different from a width of at least one of the second through hole and the groove.

6. The stage according to claim 4, wherein in a cross-sectional view, at least one of the first through hole, the second through hole, and the groove have a tapered shape.

7. The stage according to claim 6, wherein the tapered shape increases in width toward a surface of the first metal plate.

8. The stage according to claim 6, wherein the tapered shape decreases in width toward a surface of the first metal plate.

9. A stage, comprising:
a first metal plate comprising a first groove;
a second metal plate comprising a through hole, below the first metal plate;
a third metal plate comprising a second groove, below the second metal plate; and
a circulating flow path and a heater with the first groove interposed therebetween,
wherein the through hole and the second groove are connected to each other,
wherein the first groove overlaps the through hole, and
wherein one end of the through hole is closed by the first metal plate.

10. The stage according to claim 9, wherein in a cross-sectional view, a width of the first groove is different from a width of at least one of the through hole and the second groove.

11. A stage, comprising:
a first metal plate comprising a first groove;
a second metal plate comprising a first through hole, below the first metal plate;
a third metal plate comprising a second groove, below the second metal plate;
a circulating flow path and a heater with the first groove interposed therebetween;
a first heat insulating portion in which the groove, the first through hole, and the second groove are connected to one another; and
in a plan view, a second heat insulating portion overlaps the heater.

12. The stage according to claim 11, wherein the second heat insulating portion comprises a third groove in the second plate.

13. The stage according to claim 12, wherein the second heat insulating portion further comprises a second through hole provided in the third plate.

14. The stage according to claim 12, further comprising a third heat insulating portion overlapping the heater in a plan view,
wherein the third heat insulating portion comprises a fourth groove provided in the third metal plate.

15. The stage according to any one of claims 1 to 14, wherein a difference between a minimum surface temperature and a maximum surface temperature of the first metal plate is higher than or equal to 20°C.
